# EUROPÄISCHE PATENTSCHRIFT

(11) **EP 0 539 770 B1**
(45) Veröffentlichungstag und Bekanntmachung des Hinweises auf die Patenterteilung: **22.02.1995**
(21) Anmeldenummer: 92117100.5
(22) Anmeldetag: 07.10.1992
(51) Int. Cl.: B60T 8/36, B60T 13/68, H05K 7/14

(54) **Elektrohydraulische Druckregelvorrichtung, insbesondere Bremsdruckregelvorrichtung für Kraftfahrzeuge**
Electrohydraulic pressure control device, in particular a brake pressure control device for motor vehicles
Dispositif électrohydraulique de régulation de pression, en particulier dispositif de régulation de la pression de freinage des véhicules automobiles

(30) Priorität: 30.10.1991 DE 4135745
(43) Veröffentlichungstag der Anmeldung: 05.05.1993
(73) Patentinhaber: ITT Automotive Europe GmbH, 60488 Frankfurt (DE)
(72) Erfinder: Reinartz, Hans-Dieter, W-6000 Frankfurt/Main 90 (DE); Volz, Peter, Dr., W-6100 Darmstadt (DE); Czarnetzki, Edwin, W-6254 Elz (DE)
(74) Vertreter: Portwich, Peter

(56) Entgegenhaltungen:
- EP-A- 0 105 219
- WO-A-89/10286
- WO-A-91/10583
- DE-A- 3 742 320
- DE-A- 3 919 760
- US-A- 4 697 863

## Beschreibung

Die Erfindung betrifft eine elektrohydraulische Druckregelvorrichtung, insbesondere Bremsdruckregelvorrichtung für Kraftfahrzeuge, nach dem Oberbegriff des Anspruchs 1.

Aus dem Teves-Handbuch der elektronischen Bremssysteme, Ausgabe 1989, Kapitel 4.2.5 und Kapitel 5.2.2, ist eine Druckregelvorrichtung bekannt, dessen mehrere Elektromagnetventile aufnehmenden Ventilaufnahmekörper mit einem die Magnetventile im Ventilaufnahmekörper verschließenden Deckel versehen ist, wobei der Deckel entweder mittels mehreren Befestigungsmuttern an Stehbolzen im Ventilaufnahmekörper gehalten ist oder am Ventilblock verrastet werden kann. Zur Abdichtung der Kontaktstellen zwischen dem Deckel und dem Ventilaufnahmekörper, bzw. an den Befestigungsmuttern des Deckels, sind deshalb Dichtmittel vorgesehen, die einen uneingeschränkten Feuchteschutz der im Innenraum des Deckels befindlichen Teile gewährleisten sollen.

Wenig vorteilhaft anzusehen ist bei den oben beschriebenen Druckregelvorrichtungen die verhältnismäßig aufwendigen und damit teuren wie auch nur partiell wirksamen Abdichtungsmaßnahmen. Auch die relativ großen erforderlichen Anpreßkräfte auf die mit Flüssigdichtmittel oder Formdichtungen versehenen Kontaktflächen zwischen dem Ventilaufnahmekörper und dem Deckel ermöglichen keinen vollkommenen Korrosionsschutz der Druckregelvorrichtung. Daher bedarf es insbesondere bei Verwendung von Stahlventilblöcken besonderer Oberflächenbehandlungsmaßnahmen, um den gewünschten Korrosionsschutz gewährleisten zu können. Die vorgenannten Druckregelvorrichtungen haben zudem den Nachteil, daß eine Anpassug an verschiedene Anlagensysteme nur mit relativ großen konstruktiven wie auch fertigungstechnischen Veränderungen zu realisieren ist.

Aus dem Stand der Technik (EP-A-0105219) geht ein Steuer- oder Regelsystem hervor, das aus wenigstens einem Meßwertgeber, einer damit verbundenen Auswerteschaltung und wenigstens einem Magnetventil besteht, das mit einem hydraulischen oder pneumatischen Betätigungssystem in Verbindung steht. Die Auswerteschaltung und der davon anzusteuernde Elektromagnet des Magnetventils sind in einem gemeinsamen Gehäuse untergebracht. Wenigstens ein Magnetventil ist in einem Block untergebracht, der die elektrohydraulische Druckregelvorrichtung bildet und auf dem das Gehäuse mit der Auswerteschaltung und dem Magnetventil befestigt ist. Über einen oder mehrere aus dem Steuer- und Reglergehäuse herausgeführten und von dem Elektromagneten verschiebbaren Stößel werden die Druckmodulationsventile in der elektrohydraulischen Druckregelvorrichtung geschaltet.

Ein die Druckregelvorrichtung umschließende Korrosionsschutzschicht ist nicht vorgesehen. Die elektrohydraulische Druckregelvorrichtung ist vielmehr Bestandteil eines seitlich dazu angeordneten Bremskraftverstärkers, so daß die elektrohydraulische Druckregelvorrichtung mit dem Bremskraftverstärker die Basiseinheit bildet, auf der das Steuer- und Reglergehäuse angeflanscht ist. Die elektrohydraulische Druckregelvorrichtung befindet sich somit räumlich vom Steuer- und Reglergehäuse getrennt. Ein Korrosionsschutz und ein modularer Aufbau sind nicht vorgesehen.

Aus der WO-A-89/10286 ist eine elektrohydraulische Druckregelvorrichtung hervorgegangen, die mehrere in einem Ventilaufnahmekörper angeordnete Elektromagnetventile aufweist. Am Ventilaufnahmekörper ist ein Steuer- und Reglergehäuse angeflanscht, welches die Haltekräfte zwischen den beiden Bauteilen überträgt. Der aus dem Deckel der Druckregelvorrichtung hervorstehende Kontakt ist zugentlastet und damit kräftefrei mit dem elektrischen Anschluß des am Steuer- und Reglergehäuse angebrachten Steckers verbunden. Das Deckelgehäuse ist aus Kunststoff gefertigt. Der Ventilaufnahmekörper hat keinen Korrosionsschutz, der weitere Baugruppen tragen kann.

Aus der DE-A-37 42 320 ist bereits eine elektrohydraulische Druckregelvorrichtung hervorgegangen, deren am Ventilaufnahmekörper überstehenden Elektromagnetventilen mit einem aus Kunststoff bestehenden Deckel versehen ist. Der im wesentlichen blockförmige Ventilaufnahmekörper ist an seinem Umfang mit Ausnehmungen versehen, in die Winkelhaken des Deckels eingreifen. Der Deckel wird auf diese Weise am Ventilblock verankert. Am bzw. im Deckel ist ferner eine Kontaktvorrichtung angebracht, die als Mehrfachstecker mit mehreren elektrischen Kontakten ausgeführt ist und als Kontaktleiste oder Messerleiste beispielsweise zu der Ausgangsseite eines elektronischen Reglers eines ABS-Systems führt.

Daher ist es die Aufgabe der vorliegenden Erfindung, eine Druckregelvorrichtung der eingangs genannten Gattung zu verbessern, um unter Umgehung der vorgenannten Nachteile einen uneingeschränkten Korrosionsschutz bei gleichzeitiger Senkung der Herstellungs-, Montage- und Wartungskosten zu erreichen. Ferner soll unter Zuhilfenahme einheitlicher und möglichst einfacher Prüfeinrichtungen und Verfahren die Funktionsfähigkeit der mit Subsystemen verbindbaren Druckregelvorrichtung bei modifiziertem Aufbau zu kontrollieren sein.

Diese Aufgaben werden erfindungsgemäß durch die den Patentanspruch 1 gekennzeichneten Merkmale gelöst, wonach die Druckregelvorrichtung eine Basiseinheit bildet, die von einer Korrosionsschutzschicht bis auf Druckmittelanschlüsse und Anschlußmesser vollkommen umschlossen ist, wobei die Korrosionsschutzschicht zur Adaption peripherer Baueinheiten als Trägergehäuse ausgeführt ist und modular erweiterungsfähig ist, wobei die Korrosionsschutzschicht durch ein Beschichtungsverfahren eine definierte, für form- und/oder kraftschlüssige Verbindungselemente geeignete Schichtdicke aufweist.

Durch die in den Unteransprüchen aufgezeigten Maßnahmen sind zweckmäßige Ausbildungen der Erfindung angegeben, die im Zusammenhang mit den weiteren Merkmalen und Vorteilen der Erfindung nachfolgend anhand mehrerer Zeichnungen (Fig. 1 - 4) näher dargestellt und erläutert werden.

Es zeigt:
- Fig. 1: die Druckregelvorrichtung im Längsschnitt mit einer korrosionsfesten Gehäusekapsel,
- Fig. 2: ein zum Aufsatz auf die Druckregelvorrichtung geeignetes Steckermodul,
- Fig. 3: ein zu Fig. 2 alternatives Kabelmodul zur Verbindung der Druckregelvorrichtung mit einem Kabelabgang,
- Fig. 4: ein zum Aufsatz auf die Druckregelvorrichtung geeignetes Steuer- und Reglermodul.

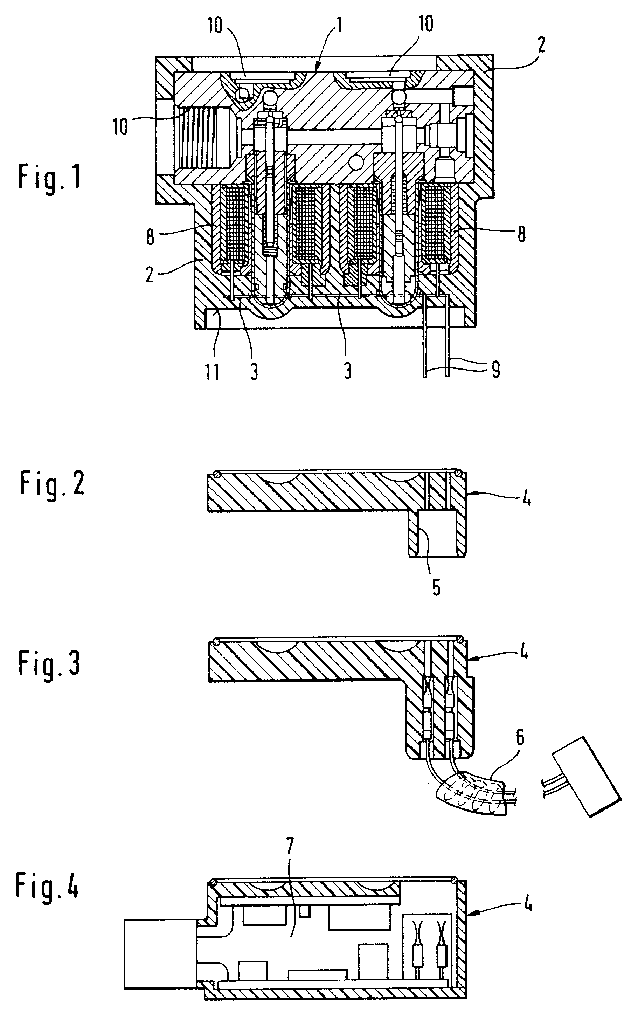

Die Fig. 1 zeigt im Längsschnitt den blockförmigen Ventilaufnahmekörper der Druckregelvorrichtung 1, mit mehreren darin vorzugsweise verstemmt gehaltenen Ventilhülsen, die die Spulen der Elektromagnetventile 8 aufnehmen. Die Stromleiter 3, die an den Elektromagnetventilen 8 angeschlossen sind, werden bis auf Ausnahme der Anschlußmesser 9 vollkommen in der die Druckregelvorrichtung 1 umschließenden hydrophobierten Korrosionsschutzschicht 2 eingebettet gehalten. Dies kann beispielsweise durch umspritzen der Druckregelvorrichtung 1 mit Kunststoff derart geschehen, daß der Ventilblock von einem korrosionsfesten Kunststoffblockgehäuse definierter Schichtdicke und zur Aufnahme weiterer Komponenten umschlossen ist. Hierbei verbleiben nur noch die Druckmittelanschlüsse 10 und die Anschlußmesser 9 von der Korrosionsschutzschicht 2 befreit. Zweckmäßigerweise ist das aus Korrosionsschutzschicht gebildete Trägergehäuse im Bereich der Anschlußmesser 9 mit einer beckenförmigen Ausnehmung 11 versehen, die zur Aufnahme spezieller Adapter bzw. Module 4 geeignet ist.

Den Figuren 2, 3, 4 sind unter Bezug auf die Figur 1 verschiedene Adapter bzw. Module 4 zugeordnet. Beispielhaft ist in Figur 2 ein plattenförmiges, einen Elektrostecker 5 aufweisendes Modul 4 dargestellt. Eine ähnliche Ausführung gemäß Figur 3 zeigt das im wesentlichen plattenförmigen Modul 4 mit einem darin anschließbaren flexiblen Kabelabgang 6, an dem sich beispielhaft ein Stecker anschließt. Die in den Figuren 2 und 3 dargestellten Module 4 ermöglichen zum Zwecke der elektrischen Stromversorgung eine unkomplizierte Anpassung an die Erfordernisse der jeweiligen Steuer und Regeleinrichtung. Sie ermöglichen eine leichte Auswechselbarkeit und einheitliche Prüfung der Druckregelvorrichtung 1, da jeweils der funktionsrelevante Grundbaustein der Druckregelvorrichtung 1 über das gleiche Stecker bzw. Messerleistensystem verfügt.

Die Figur 4 weist ein Modul 4 mit integriertem elektronischen Regler 7 auf, das analog zu den in den Figuren 2 und 3 gezeigten Adaptern lediglich auf die Anschlußmesser 9 der Druckregelvorrichtung 1 aufzuschieben ist. Damit entfällt der ansonsten benötigte, verhältnismäßig umfangreiche Kabelbaum, der zum elektrischen Regler führt, so daß der elektrische Regler 7 lediglich zur Stromversorgung, Signalverarbeitung und Ansteuerung der Magnetventile mit einer Kabelzuführung zu verbinden ist.

Zusammenfassend läßt sich feststellen, daß durch die Erfindung erhebliche Vorteile hinsichtlich der Fertigung, Prüfung, Wartung, Funktionssicherheit und Integration in den Systemverbund der an der Druckregelvorrichtung anzuschließenden Anlagen erzielt werden. Die Verwendung einer korrosionsfesten Materialschicht, die die Druckregelvorrichtung und damit die elektrischen wie auch mechanische Verbindungselemente weitgehend umschließt, läßt durch entsprechende Ausformung zu einem blockförmigen Trägergehäuse jederzeit eine Adaption peripherer Baueinheiten zu. Bei Wahrung des modularen Aufbaus kann die als Basiseinheit gekapselte Druckregelvorrichtung mittels einheitlicher Prüfeinrichtungen (gleiche Diagnosesteckverbinder im Fertigungsprozeß, gleicher Prüfablauf) rationell einer Kontrolle unterzogen werden. Die Integration der Druckregelvorrichtung in den Systemverbund der jeweils an ihr anzuschließenden Anlagenkomponenten geschieht durch Adaption von Stecker- und/oder Reglermodulen, so daß jede Spezifikation bei geringstem Teileaufwand kostengünstig erfüllt werden kann.

## Patentansprüche

1. Elektrohydraulische Druckregelvorrichtung (1), insbesondere Bremsdruckregelvorrichtung für Kraftfahrzeuge, wie Antiblockierregelvorrichtung, Antriebsschlupfregelvorrichtung, bestehend aus einem oder mehreren elektromagnetisch betätigbaren Hydraulikventilen (8), die an einem vorzugsweise blockförmigen Ventilaufnahmekörper (12) angeordnet sind, mit Spulen, die den Ventilaufnahmekörper (12) überragen, wobei die Spulen an ihren den Ventilaufnahmekörper (12) überragenden Teilen mit Stromleiter (3) versehen sind, dadurch **gekennzeichnet**, daß die Druckregelvorrichtung (1) eine Basiseinheit bildet, die von einer Korrosionsschutzschicht (2) bis auf Druckmittelanschlüsse (10) und Anschlußmesser (9) vollkommen umschlossen ist, und daß die Korrosionsschutzschicht (2) zur Adaption peripherer Baueinheiten (5, 6) als Trägergehäuse ausgeführt ist und modular erweiterungsfähig ist, wobei die Korrosionsschutzschicht (2) durch ein Beschichtungsverfahren eine definierte, für form- und/oder kraftschlüssige Verbindungselemente geeignete Schichtdicke aufweist.

2. Elektrohydraulische Druckregelvorrichtung nach Anspruch 1, dadurch **gekennzeichnet**, daß die Korrosionsschutzschicht (2) aus einem nichtmetallischen organischen Werkstoff, insbesondere aus einer die Druckregelvorrichtung (1) umschließenden Kunststoffummantelung, besteht.

3. Elektrohydraulische Druckregelvorrichtung nach Anspruch 1 oder 2, dadurch **gekennzeichnet**, daß die Korrosionsschutzschicht (2) durch das Umspritzen oder das Umgießen der Druckregelvorrichtung (1) mit Kunststoff gebildet ist.

4. Elektrohydraulische Druckregelvorrichtung nach mindestens einem der vorhergehenden Ansprüche, dadurch **gekennzeichnet**, daß die Korrosionsschutzschicht (2) eine gehäuseblockförmige Geometrie, im wesentlichen konform zu der der Druckregelvorrichtung (1), aufweist.

5. Elektrohydraulische Druckregelvorrichtung nach mindestens einem der vorhergehenden Ansprüche 1 bis 4, dadurch **gekennzeichnet**, daß auf aus der Korrosionsschutzschicht (2) hervorstehenden Stromleiter (3) der Druckregelvorrichtung (1) wenigstens ein Modul (4) aufsetzbar ist, in dem zumindest ein Elektrostecker (4) und/oder ein flexibler Kabelabgang (6), insbesondere zum Anschluß an eine Elektrosteckverbindung, integriert ist.

6. Elektrohydraulische Druckregelvorrichtung nach Anspruch 5, dadurch **gekennzeichnet**, daß in dem Modul (4) ein elektronischer Regler (7) oder zumindest Teile des elektronischen Reglers (7) integriert sind und daß das Modul an der als Trägergehäuse ausgebildeten Korrosionsschutzschicht (2) gehalten ist.

7. Elektrohydraulische Druckregelvorrichtung nach mindestens einem der vorhergehenden Ansprüche 5 bis 6, dadurch **gekennzeichnet**, daß das Modul (4) vorzugsweise aus einem nichtmetallischen organischen Werkstoff besteht, das durch Spritzgießen hergestellt und auf der Korrosionsschutzschicht (2) der Druckregelvorrichtung (1) aufgesteckt ist.

## Claims

1. An electrohydraulic pressure control apparatus (1), in particular a brake pressure control apparatus for automotive vehicles, such as an anti-locking apparatus, traction slip control apparatus, being composed of one or a plurality of electromagnetically actuatable hydraulic valves (8) which are arranged at a preferably block-shaped valve accommodating body (12), with coils which surmount the valve accommodating body (12), the said coils being provided at their parts surmounting the valve accommodating body (12) with a current conductor (3),
**characterized** in that the pressure control apparatus (1) forms a basic unit which, apart from pressure agent connections (10) and connecting blades (9), is entirely enclosed by a corrosion-preventive layer (2), and in that the corrosion-preventive layer (2) is provided as a carrier housing to adapt peripheral construction units (5, 6) and permits to be extended modularly, to which end the corrosion-preventive layer (2), owing to a coating method, has a defined layer thickness which is appropriate for positively and/or operatively engaged connecting elements.

2. An electrohydraulic pressure control apparatus as claimed in claim 1,
**characterized** in that the corrosion-preventive layer (2) consists of a nonmetallic organic material, in particular a plastic material casing which encloses the pressure control apparatus (1).

3. An electrohydraulic pressure control apparatus as claimed in claim 1 or in claim 2,
**characterized** in that the corrosion-preventive layer (2) is formed by spray-coating or by cast coating the pressure control apparatus (1) with plastics.

4. An electrohydraulic pressure control apparatus as claimed in at least one of the preceding claims,
**characterized** in that the corrosion-preventive layer (2) presents a housing block-shaped geometry substantially in conformity with that of the pressure control apparatus (1).

5. An electrohydraulic pressure control apparatus as claimed in at least one of the preceding claims 1 to 4,
**characterized** in that onto current conductors (3) of the pressure control apparatus (1) which project from the corrosion-preventive layer (2) at least one module (4) is superimposable in which at least one electric plug (4) and/or one flexible outgoing cable (6) is integrated, in particular for coupling to an electric plug-type connection.

6. An electrohydraulic pressure control apparatus as claimed in claim 5,
**characterized** in that in the module (4) an electronic controller (7) or at least parts of the electronic controller (7) are integrated, and in that the module is retained at the corrosion-preventive layer (2) provided in the shape of a carrier housing.

7. An electrohydraulic pressure control apparatus as claimed in at least one of the preceding claims 5 to 6,
**characterized** in that the module (4) is preferably made of a nonmetallic organic material by injection moulding and is plugged onto the corrosion-preventive layer (2) of the pressure control apparatus (1).

## Revendications

1. Dispositif de régulation de pression (1) de type électrohydraulique, notamment dispositif de régulation de pression de freinage pour véhicule automobile, tel que dispositif de régulation antiblocage, dispositif de régulation du glissement de traction, constitué d'une ou plusieurs valves hydrauliques (8) à actionnement électromagnétique qui sont disposées sur un corps de logement de valves (12), de préférence en forme de bloc, qui comporte des bobines qui font saillie hors du corps de logement de valves (12), les bobines étant pourvues de conducteurs de courant (3) à l'endroit de leurs parties qui font saillie hors du corps de logement de valves (12), caractérisé en ce que le dispositif de régulation de pression (1) constitue un ensemble unitaire de base qui est parfaitement enveloppé d'une couche anticorrosion (2), à l'exception de raccords d'agent de pression (10) et de lames de connexion (9), et en ce que, en vue de l'adaptation à des ensembles unitaires périphériques (5, 6), la couche anticorrosion (2) est réalisée sous la forme d'un boîtier porteur et est susceptible dune extension modulaire, la couche (2) de protection vis-à-vis de la corrosion présentant, au moyen d'un procédé de revêtement, une épaisseur définie de couche convenant pour des éléments de liaison par complémentarité de formes et/ou par application de force.

2. Dispositif de régulation de pression de type électrohydraulique selon la revendication 1, caractérisé en ce que la couche anticorrosion (2) est formée d'une matière organique non métallique, notamment d'une enveloppe en matière plastique qui entoure le dispositif de régulation de pression (1).

3. Dispositif de régulation de pression de type électrohydraulique selon l'une des revendications 1 et 2, caractérisé en ce que la couche anticorrosion (2) est formée par pulvérisation ou coulée d'une matière plastique tout autour du dispositif de régulation de pression (1).

4. Dispositif de régulation de pression de type électrohydraulique selon au moins l'une des revendications précédentes, caractérisé en ce que la couche anticorrosion (2) a une configuration géométrique en forme de bloc de boîtier, essentiellement conforme à la configuration géométrique du dispositif de régulation de pression (1).

5. Dispositif de régulation de pression de type électrohydraulique selon au moins l'une des revendications 1 à 4, caractérisé en ce qu'au moins un module (4) peut être posé sur des conducteurs de courant (3) du dispositif de régulation de pression (1) qui font saillie hors de la couche anticorrosion (2) et en ce que, dans ce module, il est intégré au moins une prise électrique (4) et/ou une sortie par câble (6) flexible, notamment pour la connexion à un raccord électrique.

6. Dispositif de régulation de pression de type électrohydraulique selon la revendication 5, caractérisé en ce qu'un régulateur électronique (7) ou au moins des parties d'un régulateur électronique (7) est intégré ou sont intégrées dans le module (4) et en ce que le module est maintenu sur la couche anticorrosion (2) réalisée sous la forme d'un boîtier porteur.

7. Dispositif de régulation de pression de type électrohydraulique selon au moins l'une des revendications 5 à 6, caractérisé en ce que le module (4) est constitué de préférence d'une matière organique non métallique, est réalisé par moulage par injection et est emboîté sur la couche anticorrosion (2) du dispositif de régulation de pression (1).
